# EUROPÄISCHE PATENTSCHRIFT

(11) **EP 4 385 080 B1**
(45) Veröffentlichungstag und Bekanntmachung des Hinweises auf die Patenterteilung: **27.05.2026**
(21) Anmeldenummer: 22765029.8
(22) Anmeldetag: 09.08.2022
(51) Int. Cl.: H01M 4/1395

(54) **VERFAHREN ZUR HERSTELLUNG VON SILIZIUM-ELEKTRODEN ALS ANODEN FÜR LITHIUM-BATTERIEN**
METHOD FOR PRODUCING SILICON ELECTRODES AS ANODES FOR LITHIUM BATTERIES
PROCÉDÉ DE PRODUCTION D'ÉLECTRODES EN SILICIUM EN TANT QU'ANODES POUR BATTERIES AU LITHIUM

(30) Priorität: 09.08.2021 DE 102021120615
(43) Veröffentlichungstag der Anmeldung: 19.06.2024
(73) Patentinhaber: NorcSi GmbH, 06120 Halle (Saale) (DE)
(72) Erfinder: REICHMANN, Udo, 01723 Wilsdruff (DE); NEUBERT, Marcel, 01731 Kreischa (DE); KRAUSE-BADER, Andreas, 01159 Dresden (DE)
(74) Vertreter: Lippert Stachow Patentanwälte Rechtsanwälte Partnerschaft mbB
(86) Internationale Anmeldenummer: PCT/EP2022/072295
(87) Internationale Veröffentlichungsnummer: WO 2023/017010

(56) Entgegenhaltungen:
- CHANG-MOOK HWANG ET AL: "Electrochemical characterizations of multi-layer and composite silicongermanium anodes for Li-ion batteries using magnetron sputtering", JOURNAL OF POWER SOURCES, ELSEVIER, AMSTERDAM, NL, vol. 196, no. 16, 20 October 2010 (2010-10-20), pages 6772 - 6780, XP028226103, ISSN: 0378-7753, [retrieved on 20101102], DOI: 10.1016/J.JPOWSOUR.2010.10.061
- ANTONIA REYES JIMÉNEZ ET AL: "A Step toward High-Energy Silicon-Based Thin Film Lithium Ion Batteries", ACS NANO, vol. 11, no. 5, 24 April 2017 (2017-04-24), US, pages 4731 - 4744, XP055583385, ISSN: 1936-0851, DOI: 10.1021/acsnano.7b00922

## Beschreibung

Die Erfindung betrifft ein Verfahren zur Herstellung einer Silizium-Elektrode als Anode für Lithium-Batterien, bei dem auf einem Substrat, vorzugsweise Kupfer, eine erste Siliziumschicht abgeschieden wird, die anschließend einer Kurzzeittemperung unterzogen wird.

Die elektrochemische Energiespeicherung ist ein wesentlicher Grundpfeiler einer weltweit angestrebten Energiewende, um den fluktuierenden regenerativ erzeugten Strom zwischen zu speichern sowie für stationäre und mobile Anwendungen bereitzustellen. Um einer rohstoffbedingten Verknappung und damit einer Erhöhung der Kosten für insbesondere Sekundärbatterien entgegenzuwirken, bedarf es neben der Diversifizierung der Energiespeicherkonzepte auch neuer Materialien. Diese sollten einerseits die technische Performance entsprechender Energiespeicherkonzepte verbessern (u. a. Kapazität, Energiedichte, Lebensdauer), andererseits auch die Herstellungskosten minimieren. Letzteres kann insbesondere durch die Verwendung von gut verfügbaren chemischen Elementen, wie es das Silizium darstellt, für das bereits eine breite Technologiebasis besteht, gewährleistet werden.

Batterien sind elektrochemische Energiespeicher und werden in Primär- und Sekundärbatterien unterschieden.

Primärbatterien sind elektrochemische Stromquellen, bei denen chemische Energie irreversibel in elektrische Energie umgewandelt wird. Eine Primärbatterie ist somit nicht wiederaufladbar. Sekundärbatterien, auch Akkumulatoren genannt, hingegen sind wieder aufladbare elektrochemische Energiespeicher, bei denen die ablaufende chemische Reaktion umkehrbar ist, so dass eine Mehrfachnutzung möglich ist. Elektrische Energie wird beim Laden in chemische Energie, beim Entladen wiederum von chemischer in elektrische Energie umgewandelt.

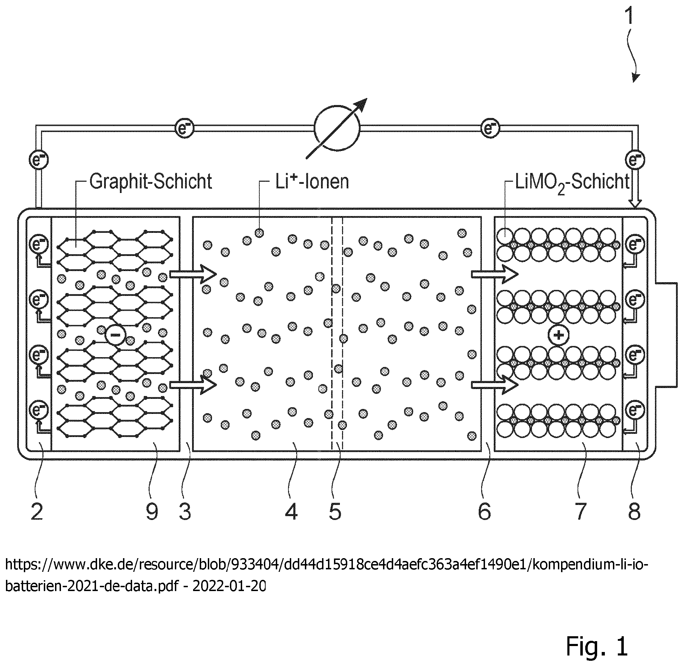

Batterie ist der Oberbegriff für zusammengeschaltete Zellen. Zellen sind galvanische Einheiten, die aus zwei Elektroden, Elektrolyten, Separator und Zellgehäuse bestehen. Figur 1 zeigt einen beispielhaften Aufbau und die Funktion einer Lithium-Ionen-Zelle beim Entladevorgang. Die Bestandteile einer Zelle werden nachfolgend kurz erläutert.

Jede Li-Ionen-Zelle besteht aus zwei unterschiedlichen Elektroden 7, 9, einer im geladenen Zustand negativ geladenen Elektrode 7 und einer im geladenen Zustand positiv geladenen Elektrode 9. Da bei der Energieabgabe, also bei der Entladung, Ionen von der negativ geladenen Elektrode zur positiv geladenen Elektrode wandern, wird die positiv geladene Elektrode Kathode 7 und die negativ geladene Elektrode Anode 9 genannt. Die Elektroden setzen sich jeweils aus einem Stromableiter 2, 8 (auch Kollektor genannt) und einem darauf aufgebrachten Aktivmaterial zusammen. Zwischen den Elektroden befinden sich zum einen der ionenleitende Elektrolyt 4, der den notwendigen Ladungsaustausch ermöglicht, und der Separator 5, der die elektrische Trennung der Elektroden gewährleistet.

Die Kathode besteht beispielsweise aus Mischoxiden, die auf einem Aluminiumkollektor aufgebracht sind.

Übergangsmetalloxide mit Cobalt (Co), Mangan (Mn) und Nickel (Ni) oder Aluminiumoxid (Al₂O₃) sind dabei die gängigsten Verbindungen. Die aufgebrachte Metalloxidschicht dient bei der Entladung der Zelle zur Einlagerung der Lithium-Ionen.

Die Anode der Li-Ionen-Zelle kann aus einer Kupferfolie als Kollektor und einer Schicht aus Kohlenstoff als Aktivmaterial bestehen. Als Kohlenstoffverbindung wird in der Regel natürlicher oder künstlicher Graphit verwendet, da er ein niedriges Elektrodenpotential besitzt und eine geringe Volumenausdehnung beim Lade- und Entladevorgang aufweist. Während des Ladevorgangs werden Lithium-Ionen reduziert und in die Graphitschichten eingelagert.

In Aufbauten für Lithium-Ionen-Batterien liefert typischerweise die Kathode die Lithiumatome zum Laden und Entladen in der Anode, die Batteriekapazität ist daher limitiert durch die Kathodenkapazität. Wie bereits erwähnt, sind typische bisher verwendete Kathodenmaterialien z. B. Li(Ni,Co,Mn)O₂ und LiFePO₄. Aufgrund des Aufbaus der Kathode durch Lithium-Metalloxide ist eine Steigerung der Kapazität nur unwesentlich möglich.

Es ist auch bekannt, bei Li-Batterie-Anoden anstelle Kohlenstoff Silizium zu verwenden. Silizium als Anodenmaterial weist eine hohe Speicherkapazität von 3579 mAh/g bei Raumtemperatur gegenüber den herkömmlichen kohlenstoffartigen Materialien, wie z. B. Graphit mit einer Speicherkapazität von 372 mAh/g, auf. Herausforderungen bei der Nutzung von Silizium als Anodenmaterial ergeben sich jedoch hinsichtlich der zum Teil erheblichen Volumenänderung (Volumenkontraktion und -expansion) der Wirtsmatrix während der Einlagerung und der Auslagerung der mobilen Ionenspezies bei Aufladung und Entladung entsprechender Energiespeicher. Die Volumenänderung liegt für Graphit bei ca. 10%, für Silizium dagegen bei ca. 400%. Die Volumenänderung des Anodenmaterials bei Verwendung von Silizium führt zu inneren Spannungen, Rissbildung, Pulverisierung des aktiven Materials der Wirtsmatrix (Silizium) und schließlich zur kompletten Zerstörung der Anode.

Um die Volumenänderung zu verringern, nutzen bisher bekannte Verfahren zur Herstellung von Batterien nanostrukturierte kohlenstoff- bzw. siliziumbasierte Nanopartikel oder Nanodrähte als Anodenmaterialien in aufladbaren Lithium-Batterien. Der größte Vorteil solcher Nanomaterialien ist neben der Erhöhung der Geschwindigkeit der Einlagerung und der Auslagerung des Lithiums auch der Oberflächeneffekt. Darunter ist zu verstehen, dass sich bei einer großen Oberfläche die Kontaktfläche für den Elektrolyten und den damit verbundenen Fluss von Li+ -Ionen (Leerstellen) durch die Grenzfläche vergrößert, wie in der Druckschrift M. R. Zamfir, H. T. Nguyen, E. Moyen, Y. H. Leeac and D. Pribat: Silicon nanowires for Li-based battery anodes: a review, Journal of Materials Chemistry A (a review), 1, 9566 (2013) beschrieben ist. Vor allem siliziumbasierte Nanopartikel und Nanodrähte weisen stabilere Silizium- Strukturen in Bezug auf die Volumenänderung des Siliziums nach der Einlagerung des Lithiums bis zu einer bestimmten Si-Strukturgröße auf, wie in der Druckschrift M. Green, E. Fielder, B. Scrosati, M. Wachtier and J. S. Moreno: Structured Silicon anodes for lithium battery applications, Electrochem. Solid- State Lett, 6, A75-A79 (2003) beschrieben ist. Als strukturelle Grenze wird 1µm für amorphes und 100nm für kristallines Silizium angesehen, damit eine gleichmäßige Volumenänderung erfolgen kann.

Somit kann die Volumenexpansion im Anodenmaterial zum einen durch den freien Raum zwischen den Nanostrukturen aufgefangen werden, zum anderen erleichtert die Verkleinerung der Strukturen die Phasenübergänge bei der Legierungsbildung, was zu einer Leistungssteigerung des Anodenmaterials führt. In CHANG-MOOK HWANG ET AL: "Electrochemical characterizations of multi-layer and composite silicongermanium anodes for Li-ion batteries using magnetron sputtering", JOURNAL OF POWER SOURCES, ELSEVIER, AMSTERDAM, NL, Bd. 196, Nr. 16, 20. Oktober 2010 (2010-10-20), Seiten 6772-6780 wird eine Multilagenstruktur aus Si/Ge mit max. 25 nm dicken Si-Lagen als Anode für Lithium-Ionen-Batterien untersucht. In ANTONIA REYES JIMeNEZ ET AL: "A Step toward High-Energy Silicon-Based Thin Film Lithium Ion Batteries", ACS NANO, Bd. 11, Nr. 5, 24. April 2017 (2017-04-24), Seiten 4731-4744 wird eine Si/C-Mehrschichten-Anode mit max. 140 nm dicken Si-Lagen beschrieben.

Die Nutzung der siliziumbasierten Nanopartikel und Nanodrähte ist jedoch sehr aufwendig. Die Si-Nanostrukturen werden sowohl durch physikalische und chemische Verfahren hergestellt, inklusive mit Mahlen in Kugelmühlen (Ball milling), Sputterabscheidung, PVD/CVD Verfahren, chemische bzw. elektrochemisches Ätzen und Reduktion von SiO₂ (Feng, K. et al. Silicon-Based Anodes for Lithium-Ion Batteries: From Fundamentals to Practical Applications. Small 14, 1702737 (2018)). Anschließend werden nach dem Stand der Technik die hergestellten Nanostrukturen mit leitfähigem Kohlenstoff und Binder vermischt und großtechnisch auf einen Kupfer-Stromkollektor mittels Kalandrieren und Trocknen zum Anodenbau aufgebracht. Der Nachteil dieser Verfahren ist, dass sich im Batteriebetrieb die Nanostrukturen voneinander trennen und damit die Anode an Kapazität verliert. Ein weiterer Nachteil ist die große Oberfläche der Nanostrukturen, die zu einem hohen Verbrauch an Elektrolyt durch Bildung einer SEI (Solid electrolyte interphase) und dem Austrocknen der Batterie führt.

In der WO 2017/140581 A1 ist daher ein Verfahren zur Herstellung von auf Silizium basierenden Anoden für Sekundärbatterien beschrieben, welches diese Nachteile nicht aufweist. Bei diesem Verfahren wird auf einem Metallsubstrat, das als integrierter Stromableiter dient, eine Silizium-Schicht abgeschieden und anschließend einer Blitzlampentemperung unterzogen. In der Regel wird ein Blitzlampenprozess verwendet, um schnell und lokal Silizium zu schmelzen und zu kristallisieren, z. B. in der Halbleiterindustrie und für Solarzellen. Das ist aber nicht das Ziel des in der WO 2017/140581 A1 beschriebenen Verfahrens. Vielmehr wird die Blitzlampentemperung folgendermaßen eingesetzt: Im Allgemeinen kann eine Kristallisation des Siliziums erst bei ca. 700 °C herbeigeführt werden. Diese Temperatur wird mit einer Blitzlampentemperung für eine kurze Zeit an der Oberfläche erreicht, wobei das restliche Substrat deutlich kühler bleibt. Schon bei deutlich niedrigeren Temperaturen, ab ca. 200°C, findet auf der Oberfläche und entlang der Korngrenzen des Metallsubstrates eine Diffusion statt, da an der Grenzfläche zu einem Metall die kovalente Bindung der Si-Atome abgeschwächt ist. Dies wurde bei mehreren Metall-/Halbleitersystemen (z. B. Au/a-Si und Ag/a-Si) bereits gezeigt und hat sich als energetisch begünstigt erwiesen, wie in der Druckschrift Z. M. Wang, J. Y. Wang, L. P. H. Jeurgens, E. J. Mittemeijer: Thermodynamics and mechanism of metal-induced crystallization in immiscible alloy Systems: Experiments and calculations on AI/a-Ge and Al/a-Si bilayers, Physical Review B 77, 045424 (2008) beschrieben ist. Darüber hinaus kann eine Kristallisation des Siliziums durch das Einbringen von Metall bei vergleichsweise niedriger Temperatur erzielt werden. Man spricht dabei von einer metall-induzierten Kristallisation. Sehr stark vereinfacht, kann das kristalline Wachstum nach Unterschreiten der Schmelztemperatur einsetzen, dies kann als Kriterium für die Phasenumwandlung genutzt werden. Mit dem in der WO 2017/140581 A1 beschriebenen Verfahren lassen sich mehrphasige Silizium-Metall-Strukturen herstellen, die die durch Delithiierung und Lithiierung herbeigerufene Volumenänderung abfedern und für eine Stabilisierung des gesamten Materialverbundes sorgen. Unter der Lithiierung wird die Einlagerung der Lithium-Ionen im Wirtsmaterial, z. B. des Siliziums oder des Graphits verstanden.

Die mit dem aus der WO 2017/140581 A1 bekannten Verfahren herstellbaren Si-Anoden sind ein Gemisch aus Silizium, reinen Metallen und Siliziden, falls nur eine Kupfer-Folie als Substrat verwendet und auf dem eine Siliziumschicht abgeschieden wird, d. h. es entsteht ein Gefüge aus Kupfer, Kupfersilizid und Silizium. Die Vorteile derart hergestellter Si-Anoden gegenüber Si-Anoden aus Nanopartikeln oder -drähten sind eine hohe elektrische Leitfähigkeit gegenüber reinem Silizium und auch konventionellem Graphit, da Silizide eine ca. zwei Größenordnungen bessere elektrische Leitfähigkeit als Graphit aufweisen. Des Weiteren wird eine sehr gute Anhaftung zwischen der Si-Schicht als Aktivmaterial und dem Kupfersubstrat erreicht, wobei das Kupfer aus einer Kupferfolie in die abgeschiedene Si-Schicht durch die Blitzlampentemperung diffundiert. Aufgrund der aktiven Bereiche für die Lithiumeinlagerung, die durch das reine Silizium gebildet werden und den inaktiven Bereichen, die durch die Silizide / Metalle in der Matrix gebildet werden, wird die bekannte nachteilige Volumenexpansion beim Laden kompensiert. Vorteilhaft ist auch, dass durch den Lagenaufbau nur eine geringe Fläche eine Grenzschicht zum Elektrolyten bildet, wobei durch die geringe Oberfläche weniger Elektrolytzersetzung als bei nanostrukturiertem Aktivmaterial auftritt. Als Aktivmaterial wird die Siliziumschicht bezeichnet.

Ein Nachteil des in der WO 2017/140581 A1 beschriebenen Verfahrens liegt aber darin, dass infolge der Blitzlampentemperung die Si-Schicht unkontrolliert zu Kupfersilizid reagiert, wobei die Umwandlungsreaktion immer an der Grenzfläche Cu-Si-Schicht beginnt. Als Resultat der Reaktion verbleibt entweder kein Silizium als Aktivmaterial für die Einlagerung des Lithiums oder wenn der Energieeintrag so gering ist, findet keine ausreichende Reaktion statt und die Schicht ist im Batteriebetrieb nicht hinreichend stabil und führt somit zu einem Kapazitätsverlust der Batterie. Für eine ausreichende Zielkapazität bei der Herstellung der Lithium-Batterie sind ausreichend dicke Si-Schichten (10µm entspricht etwa 4mAh/cm²) notwendig. Wird die Umwandlungsreaktion Cu + Si zu Kupfersilizid durch ein Temperverfahren, auch durch die Blitzlampentemperung, unkontrolliert in Gang gesetzt, würde dabei das gesamte Kupfersubstrat, z. B. eine Kupferfolie, mit dem Silizium vollständig zu Kupfersilizid reagieren und mit dem Verlust des Stromkollektors der Lithium-Batterie einhergehen.

Es ist daher die Aufgabe der vorliegenden Erfindung ein Verfahren anzugeben, das eine Kontrolle der Anteile an Silizium zu Silizid und Metall zulässt. Dabei sollte ein Kompromiss gefunden werden zwischen dem maximalen Anteil an reinem Silizium, im besten Fall amorph oder nano-kristallin, das als Aktivmaterial für die Lithiumeinlagerung zur Verfügung stehen muss, bei gleichzeitig ausreichend vielen inaktiven Bereichen, um Stabilität und eine gute elektrische Leitfähigkeit zu erreichen, und bei einer ausreichenden Anoden-Schichtdicke mit einem hohen Siliziumanteil für eine hohe Kapazität.

Außerdem sollte das Verfahren eine Kontrolle der jeweils gebildeten Metallphase, z. B. Cu₅Si anstelle von Cu₃Si, erlauben.

Die Aufgabe wird durch ein Verfahren gemäß dem unabhängigen Anspruch 1 gelöst. Bei dem Verfahren zur Herstellung einer Silizium-Elektrode als Anode für Lithium-Batterien, bei dem auf einem Substrat, vorzugsweise Kupfer, eine erste Siliziumschicht abgeschieden wird, die anschließend einer Kurzzeittemperung unterzogen wird, wird die Abscheidung einer weiteren Siliziumschicht und die anschließende Kurzzeittemperung mindestens einmal wiederholt.

Unter einer Kurzzeittemperung wird insbesondere die Blitzlampentemperung und / oder die Lasertemperung verstanden. Die Blitzlampentemperung erfolgt mit einer Pulsdauer bzw. Temperungszeit im Bereich von 0,3 bis 20 ms und einer Pulsenergie im Bereich von 0,3 bis 100 J/cm². Bei der Lasertemperung wird die Temperungszeit von 0,01 bis 100 ms durch die Scangeschwindigkeit der lokalen Erhitzungsstelle eingestellt, um eine Energiedichte von 0,1 bis 100 J/cm² zu erzeugen. Die in der Kurzzeittemperung erreichten Heizrampen liegen im für den im Verfahren notwendigen Bereich von 10^4-10^7 K/s. Die Blitzlampentemperung nutzt hierfür ein Spektrum im sichtbaren Wellenlängenbereich, wohingegen in der Lasertemperung diskrete Wellenlängen im Bereich des infraroten (IR)- bis ultravioletten (UV)-Spektrums verwendet werden.

In einer bevorzugten Ausgestaltung des erfindungsgemäßen Verfahrens wird die Abscheidung einer weiteren Siliziumschicht und die anschließende Kurzzeittemperung zweimal oder häufiger wiederholt. Damit lassen sich Schichtdicken von mehreren Mikrometern, bevorzugt mehr als 5 µm aufbauen, ohne dass der gesamte Schichtaufbau unkontrolliert zu Kupfersilizid reagiert, was mit einem Verlust des Stromkollektors einhergehen würde.

Der Vorteil der wiederholten Si-Abscheidung und der anschließenden Kurzzeittemperung ist, dass sich mit jeder Sequenz eine stabile ("abreagierte") Schicht, d. h. Lage, mit einer abgeschlossenen Grenzfläche bildet, die als Zwischenschicht (Interface) für die nachfolgenden Lagen fungiert. Dies sorgt dafür, dass sich der Anteil Kupfer in der Schicht reduziert, so dass bereits nach zwei bis drei Sequenzen die Kupfer-Silizium-Reaktion zu Kupfersilizid nicht vollständig abläuft und ein Gradient des Kupferanteils auftritt und reines Silizium für eine hohe Kapazität verbleibt. Das wird dadurch erreicht, dass jede Lage der Lagenstruktur mit Grenzfläche als Diffusionsbarriere für den weiteren Schichtaufbau dient. Zusätzlich kann mit der Kurzzeittemperung jede Schicht, d. h. Lage individuell getempert werden. Die Lagenstruktur kann auch als Schichtstapel bezeichnet und verstanden werden.

Das erfindungsgemäße Verfahren stellt einen sehr einfachen Prozess dar mit dem eine sehr gute Haftung an der Grenzfläche Cu-Kollektor und Silizium sowie ein sehr guter elektrischer Übergang erreicht wird. Neben dem abgeschiedenen Silizium und dem Kupfer, welches aus dem Kupfer-Kollektor stammt, ist kein zusätzliches Material erforderlich.

Die beschriebene erste Ausgestaltungsvariante des erfindungsgemäßen Verfahrens kann als Vorprozess in Kombination mit den anderen folgenden beanspruchten Verfahrensschritten genutzt werden, da durch das Aufrauen der Oberfläche, als Beispiel eines positiven Effekts einer lagenweise getrennten Reaktion, eine gute Haftung für weitere Schichten entsteht, das Wachstum von Säulenstrukturen gefördert wird, so dass eine bessere Ionenleitfähigkeit erreicht werden kann sowie der Kupferanteil für Folgeprozesse gut kontrolliert werden kann. Beispielsweise kann die erste Schicht aus 1µm Silizium bestehen, die mit dem Kupfersubstrat vollständig zu CuSiₓ, zumeist Cu₃Si, reagiert. Dadurch wird eine Aufrauhung der Oberfläche und eine sehr gute Haftung zum Kupfersubstrat erreicht. Dabei wird zwar ein Teil des Kupfersubstrats verbraucht, aber durch das erfindungsgemäße Verfahren läuft die Reaktion durch die Wahl der Prozessparameter der Kurzzeittemperung kontrolliert ab, ein Verlust des Stromkollektors wird verhindert. Die starke Haftung des anschließenden zu realisierenden Lagenaufbaus auf dem Kupfersubstrat kann auch durch eine mechanische Aufrauhung oder mittels eines anderen Materials als Silizium realisiert werden.

Die sehr gute Haftung zum Substrat ist entscheidend, dass die anschließend aufgebrachten Multilagen nicht abreißen, wenn es durch die Lithium-Einlagerung während des Batteriebetriebs zu einer Volumenausdehnung kommt. Durch das erfindungsgemäße Verfahren wird erst ein stabiler Batteriebetrieb ermöglicht.

Dies ist mit dem in der WO 2017/140581 A1 beschriebenen Verfahren nicht umsetzbar. In der WO 2017/140581 A1 wird lediglich eine Siliziumschicht abgeschieden, die einer Blitzlampentemperung unterzogen wird. Die notwendige Si-Schichtdicke von bis zu 10µm für Batterieanwendungen wird dabei in einem Prozessschritt auf dem Substrat abgeschieden und durch die Blitzlampe getempert. Allerdings sind die so hergestellten Schichten spröde und platzen leicht ab oder reagieren vollständig mit dem Kupfer des Substrates, wodurch kein speicherfähiges Silizium bestehen bleibt.

Erfindungsgemäß wird vor dem Abscheiden der weiteren Siliziumschicht eine dünne Lage einer weiteren Schicht von Silizium verschiedenen Schicht aufgebracht. Diese dünne Lage der weiteren Schicht kann beispielsweise Kohlenstoff, ein Metall, ein Metalloxid oder ein Metallnitrid sein, insbesondere kann die dünne Lage der weiteren Schicht aus einem der Materialien Titan (Ti), Nickel (Ni), Aluminium (Al), Zinn (Sn), Gold (Au), Silber (Ag), Wolfram (W) und / oder Kupfer (Cu) gebildet sein. Als dünn wird eine 5 bis 200nm dicke Schicht verstanden. Die Dicke wird definiert als die Dicke, bei der die gewünschte Funktion der hinzugefügten Lage für den Fertigungsprozess, insbesondere der Kurzzeittemperung als ausreichend gilt.

Das Einfügen eines zusätzlichen Materials in die Lagen des Siliziumlagenaufbaus hat den Vorteil, dass das Kupfer des Kupfersubstrats nur zu einem sehr geringen Teil mit den aufgebrachten Schichten reagiert, was insbesondere für eine gute Haftung sorgt, und andererseits das Kupfer des Stromkollektors, durch das Unterbinden einer Reaktion mit den weiteren abgeschiedenen Schichten, nicht abgebaut wird.

Es hat sich gezeigt, dass sich die Wirkung der Kurzzeittemperung bei der Abscheidung einer weiteren von dem Substratmaterial Kupfer verschiedenen Schicht unterscheidet, insbesondere auch von zusätzlich auf das Kupfersubstrat abgeschiedenem Kupfer. Als Ursache gelten die verschiedensten chemischen Vorgänge in Verbindung mit Silizium. Dadurch können sich andere Strukturen in der erzeugten Anodenschicht bilden, z. B. Säulenstrukturen bei Nickel oder Dendrite bei Kupfer. Dendrite sind baum- oder strauchartige Kristallstrukturen. Des Weiteren können sich andere Silizide bilden, welche im Gegensatz zu Cu-Siliziden, die kein oder vernachlässigbar wenig Lithium einlagern können, auch Lithium einlagern. Die Ausnutzung der genannten Unterschiede hat den Vorteil, dass damit die Volumenausdehnung von Silizium bei Lithium Einlagerung kontrolliert werden kann. Dadurch wird die Stabilität des Batteriebetriebs deutlich erhöht.

Im Fall von Nickel als dünne Lage einer weiteren Schicht vor dem Abscheiden der weiteren Siliziumschicht bildet sich während der Kurzzeittemperung zunächst Nickel-Silizid. Wird als Kurzzeittemperung eine Blitzlampentemperung eingesetzt, wird mittels einer Blitzlichtlampe, die eine Blitzlichtdauer zwischen 0,2 ms und 20 ms und eine Energiedichte von 0.6 J/cm2 und 160 J/cm2 aufweisen kann, das Nickel wieder durch Kupfer substituiert und Nickel verbleibt als reines Metall in der Schicht. Da Nickelsilizid eine kleinere Dichte hat, entsteht Cu-Silizid mit kleinerer Dichte. Dies verbessert die Kompensation bei der Li-Einlagerung. Erfolgt die Kurzzeittemperung mittels eines Lasers (Lasertemperung) wird diese mit einer Temperungszeit im Bereich von 0,01 ms bis 100 ms durch das Einstellen einer Scangeschwindigkeit einer lokalen Erhitzungsstelle und einer Energiedichte im Bereich von 0,1 bis 100 J/cm² sowie einer Vorheizung oder Kühlung im Bereich von 4°C bis 200°C durchgeführt. Da es sich um einen Nicht-Gleichgewichtsprozess handelt, welcher nur im ms-Bereich realisierbar ist, ist der Einsatz einer Blitzlampe oder eines Lasers erforderlich.

Die Blitzlampen bestehen bevorzugt aus Gasentladungslampen, die einen Hauptteil der Strahlung im Wellenlängenbereich zwischen dem sichtbaren Bereich und dem Infrarotbereich (400 nm - 800 nm) emittieren und mit einer etwaigen Gesamtleistung von ca. 12 MW in weniger als 20 ms arbeiten und so die Probenoberflächen auf eine Temperatur von bis 2000°C gebracht werden können. Die Blitzlampenausheilung dient dazu, den metall-induzierten Schichtaustauschprozess, auch unter metall-induzierter Kristallisation bekannt, zu begünstigen.

Im Fall von Titan bildet sich Ti-Silizid, das in der richtigen Phase Li-einlagerfähig sein kann (siehe: Xu, J. et al. Preparation of TiSi2 Powders with Enhanced Lithium-Ion Storage via Chemical Oven Self-Propagating High-Temperature Synthesis. Nanomaterials 11, 2279 (2021)). Das hat den Vorteil, dass keine eindeutige Grenzfläche Li-aktiv-inaktiv existiert und dadurch ein guter elektrischer Kontakt auch während der Zyklierung existiert. Weitere Metalle wie beispielsweise Aluminium bilden keine Verbindung mit Silizium, also keine Silizide. Das hat zur Konsequenz, dass sich diese Metalle in Silizium mischen und die elektrische Leitfähigkeit erhöht wird. Im Kurzzeittemperschritt kann sich zusätzlich die Morphologie und Härte der Silizium-Metall-Schicht verbessern gegenüber dem harten reinen Silizium.

Der Kohlenstoff dient als Diffusionsbarriere zur Verhinderung der weiteren unkontrollierten Reaktion des Kupfers aus dem Substrat/Stromkollektor mit der folgenden Aktivschicht. Als Aktivschicht wird die weitere Siliziumschicht verstanden, in die Lithium eingelagert werden kann.

Die Nutzung von Kohlenstoff hat den Vorteil, dass Kohlenstoff in Form von Graphit in der Lithium-Ionen-Batterie-Herstellung bereits genutzt wird und daher leicht und verträglich in den Herstellungsprozess integriert werden kann. Ein weiterer Vorteil besteht darin, dass der gesputterte Kohlenstoff als Kupferdiffusionsbarriere einsetzbar ist und damit die Silizidbildung mindert. Kohlenstoff hat dazu noch den Vorteil, dass es sehr leicht sowie elektrisch leitfähig ist, und Lithium gut durchdiffundieren kann. Das Gewicht, die gute elektrische und ionische Leitfähigkeit sind ein Vorteil gegenüber allen anderen Metallen als Einsatz in der Zwischenschicht. Kohlenstoff kann auch als Schutzschicht an der Grenzfläche Silizium/Elektrolyt dienen, da es chemisch inert ist und wie bereits erwähnt eine gute Li+-Ionenleitfähigkeit besitzt.

In einer weiteren Ausgestaltung des erfindungsgemäßen Verfahrens wird auf die weitere Siliziumschicht vor der Kurzzeittemperung eine Metallschicht abgeschieden. Zusätzlich zu den bisher erwähnten Eigenschaften gibt es bei dieser erfindungsgemäßen Variante die Möglichkeit, dass durch die Reaktion mit dem Metall eine Aufrauhung der Oberfläche der Aktivschicht erfolgt. Dies kann die Ionenleitfähigkeit bzw. die Grenzschicht Elektrolyt-Aktivmaterial verbessern.

Die Abscheidung einer zusätzlichen Metallschicht auf der Siliziumschicht hat somit den Vorteil, dass die Silizid-Bildungsreaktion an der Grenzfläche zur Kupferfolie und zusätzlich an der Grenzfläche der oben aufgebrachten Metallschicht stattfindet. Damit ist eine gute Haftung zwischen Kupferfolie und Siliziumschicht weiter gewährleistet und gleichzeitig wird die Reaktion von Cu und Si zu Kupfersilizid durch die Metallschicht auf der Oberseite kontrolliert. Eine Metallschicht kann die Oberflächenleitfähigkeit verbessern. Wichtig für schnelle Lade-/Entladevorgänge ist eine hohe elektrische Leitfähigkeit der Batterie, sowie dass die Li+ Ionen gut in die Schichten eindringen können. Daher müssen alle Schichten und Grenzflächen möglichst leitfähig sein. Beispielsweise kann Si dotiert sehr leitfähig sein, aber mit dem Elektrolyten bzw. mit Abbauprodukten reagieren, so dass sich SiO₂ (sehr guter Isolator) oder sogar Li₄SiO₄ (Li-Silikat) bilden. Li-Silikat ist ein sehr guter Isolator und es entstehen Verluste an Li durch feste Bindung. Daher muss das im Gesamtkonstrukt der Anode verhindert werden, durch z. B. nicht geschlossene/poröse Oberflächen, leitfähige Grenzflächen, lösliche/weiche Schutzschichten. Durch eine zusätzliche Metallschicht an der Grenzfläche kann genau dies verhindert werden.

In einer vorteilhaften Ausgestaltung des erfindungsgemäßen Verfahrens wird die Metallschicht aus einem der Materialien Titan (Ti), Nickel (Ni), Aluminium (Al), Zinn (Sn), Gold (Au), Silber (Ag) und / oder Wolfram (W) gebildet. Die Vorteile sind die oben benannten.

Erfindungsgemäß wird vor dem Abscheiden der ersten Siliziumschicht auf dem Kupfersubstrat eine von Silizium verschiedene Schicht, vorzugsweise Nickel (Ni) und / oder Kupfer (Cu) abgeschieden. Das hat zum einen den Vorteil, dass mittels der Kurzzeittemperung eingestellt werden kann, wie weit die Schicht reagieren soll und zum anderen wird kein Kupfer des Stromkollektors zur Bildung des Kupfersilizids verwendet, sondern die Metallsilizid-Bildung erfolgt kontrolliert zwischen der aufgebrachten Metallschicht, wie z. B. Nickel oder Kupfer und der dann abgeschiedenen ersten Siliziumschicht.

Die Erfindung soll nachfolgend an Ausführungsbeispielen näher erläutert werden.

Die Zeichnungen zeigen
- Fig. 1: Beispielhafter Aufbau und Funktion einer Lithium-Ionen-Zelle beim Entladevorgang;
- Fig. 2: Schematische Darstellung des erfindungsgemäßen Verfahrens zur Herstellung einer Silizium-Anode für eine Lithium-Ionen-Batterie:
a) wiederholte Beschichtung des Cu-Substrats mit Silizium und anschließender Kurzzeittemperung; b) Abscheidung einer dünnen Metallschicht zwischen dem Cu-Substrat und der Si-Schicht;
- Fig. 3: Ein Multilagenaufbau hergestellt gemäß dem erfindungsgemäßen Verfahren zur Stabilisierung des Si-Schichtsystems: a) REM-SE-Aufnahme, b) REM-BSE-Aufnahme;
- Fig. 4: Aufnahme eines Multilagenaufbaus gemäß dem erfindungsgemäßen Verfahren a) vor dem Batteriebetrieb, b) nach 200 Zyklen Batteriebetrieb;
- Fig. 5: Weitere Aufnahme eines Multilagenaufbaus gemäß dem erfindungsgemäßen Verfahren.

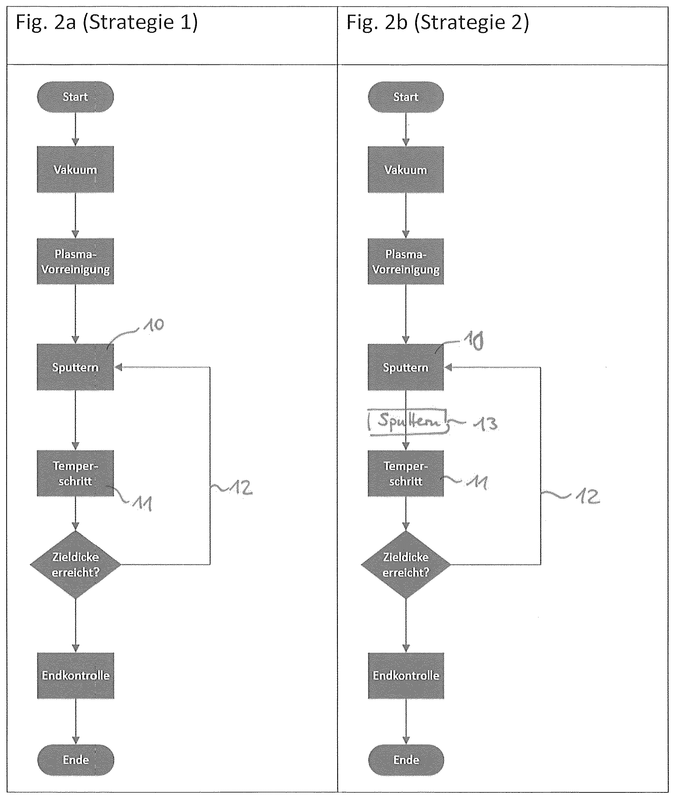

Figur 2a zeigt die erfindungsgemäßen Schritte einer ersten Verfahrensvariante in einem Ablaufdiagramm. Ein Substrat, welches gleichzeitig als Stromkollektor dient, erfährt unter Vakuumbedingungen in einer Plasmaatmosphäre eine Vorreinigung. Anschließend erfolgt der Silizium-Lagenaufbau mittels physikalischer Gasphasenabscheidung, z. B. Sputtern oder Verdampfen. Dabei wird sequentiell eine Si-Schicht 10 aufgebracht, wobei die Lagen durch eine Kurzzeittemperung 11, z. B. Blitzlampentemperung stabilisiert werden. Der Vorteil der wiederholten Si-Abscheidung 12 und anschließenden Kurzzeittemperung ist, dass sich mit jeder Sequenz eine stabile ("abreagierte") Schicht mit einer abgeschlossenen Grenzfläche bildet, die als Zwischenschicht (Interface) für die nachfolgenden Lagen fungiert.

Figur 2b zeigt die erfindungsgemäßen Schritte einer zweiten Verfahrensvariante in einem Ablaufdiagramm. Ein Substrat, welches gleichzeitig als Stromkollektor dient, erfährt unter Vakuumbedingungen in einer Plasmaatmosphäre eine Vorreinigung. Anschließend erfolgt der Silizium-Lagenaufbau mittels physikalischer Gasphasenabscheidung, z. B. Sputtern und / oder Verdampfen und das Aufbringen einer dünnen Lage einer weiteren von Silizium verschiedenen Schicht. Dabei wird zunächst eine Si-Schicht 10 und eine dünne Lage eines anderen Materials 13, z. B. Kohlenstoff, ein Metall, ein Metalloxid oder ein Metallnitrid oder Kupfer entweder auf die erste Silizium Schicht oder einer weiteren Siliziumschicht aufgebracht, wobei die Lagen durch eine Kurzzeittemperung 11 stabilisiert werden. Der Vorteil der wiederholten Si-Abscheidung 12 und zusätzlichen weiteren Schicht sowie die anschließende Kurzzeittemperung ist, dass sich z. B. im Fall von Titan Ti-Silizid bildet, das in der richtigen Phase Li-einlagerfähig sein kann. Das hat den Vorteil, dass keine eindeutige Grenzfläche Li-aktiv-inaktiv existiert und dadurch ein guter elektrischer Kontakt auch während des Batteriebetriebs existiert. Weitere Metalle wie beispielsweise Aluminium bilden keine Verbindung mit Silizium, also keine Silizide. Das hat zur Konsequenz, dass sich diese Metalle in Silizium mischen und die elektrische Leitfähigkeit erhöht wird. Im Temperschritt kann sich zusätzlich die Morphologie und Härte der Silizium-MetallSchicht verbessern gegenüber dem harten reinen Silizium.

Der Vorteil der wiederholten Si-Abscheidung und die anschließende Kurzzeittemperung ist, dass sich mit jeder Sequenz der Anteil Kupfer in der Schicht reduziert, so dass bereits nach zwei bis drei Sequenzen die Kupfer-Silizium-Reaktion zu Kupfersilizid nicht vollständig abläuft und reines Silizium verbleibt. Das wird dadurch erreicht, dass jeder Schichtstapel mit Grenzfläche als Diffusionsbarriere für den weiteren Schichtaufbau dient. Zusätzlich kann mit der Kurzzeittemperung jede Schicht individuell getempert werden.

Das erfindungsgemäße Verfahren stellt einen sehr einfachen Prozess dar mit dem eine sehr gute Haftung an der Grenzfläche Cu-Kollektor und Silizium sowie ein sehr guter elektrischer Übergang erreicht wird. Neben dem abgeschiedenen Silizium und dem Kupfer, welches aus dem Kupfer-Kollektor stammt, ist kein zusätzliches Material erforderlich. Damit kann die Batteriekapazität gegenüber Lithium-Batterien, die mittels eines herkömmlichen Verfahrens hergestellt wurden, weiter gesteigert werden. Die Abscheidung einer weiteren Siliziumschicht mit anschließender Kurzzeittemperung kann als Vorprozess in Kombination mit der Abscheidung einer dünnen Lage einer weiteren Schicht für den Siliziumlagenaufbau genutzt werden, da durch das Aufrauen der Oberfläche eine gute Haftung für weitere Schichten entsteht, das Wachstum von Säulenstrukturen gefördert wird, so dass eine bessere Ionenleitfähigkeit erreicht werden kann sowie der Kupferanteil für Folgeprozesse gut kontrolliert werden kann.

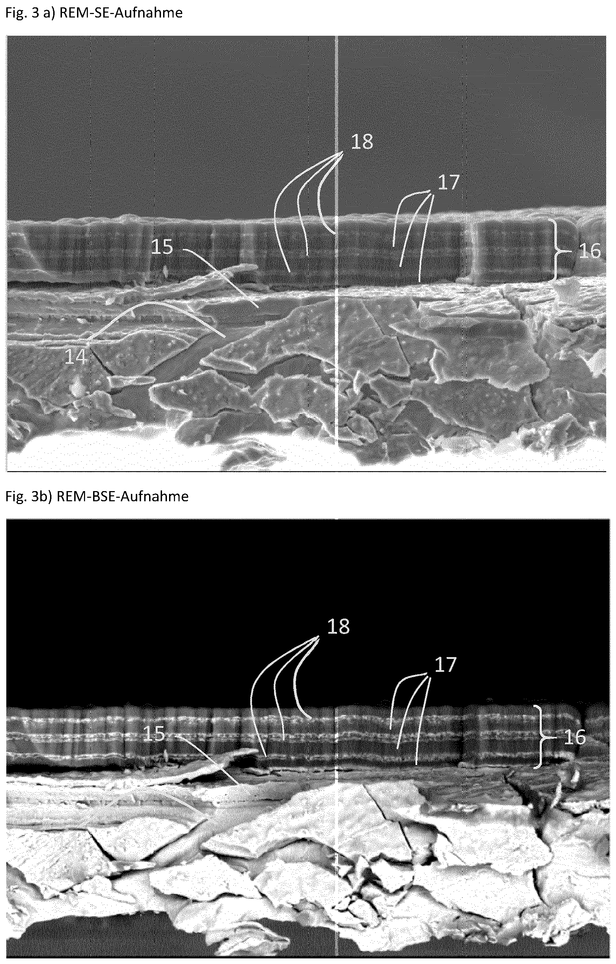

Figur 3 zeigt zwei Rasterelektronenmikroskop (REM) Aufnahmen eines Multilagenaufbaus, der gemäß dem erfindungsgemäßen Verfahren hergestellt wurde. Figur 3a zeigt eine REM-SE-Aufnahme (SE-Sekundärelektronen), wobei auf dem Kupfersubstrat 14 eine beispielsweise 1µm dicke Siliziumschicht aufgebracht wurde, die sich durch die Kurzzeittemperung, insbesondere Blitzlampentemperung mit dem Kupfersubstrat zu einer dünnen rauen nichtaktiven Schicht aus vollständig abreagiertem CuSi_{X} als Klebeschicht 15 ausgebildet hat, auf der eine Aktivschicht abgeschieden wurde, die durch einen Multilagenaufbau 16 gebildet wird, wobei abwechselnd Silizium 17 und Kupfer 18 abgeschieden wurde und die einzelnen Lagen mittels der Kurzzeittemperung stabilisiert wurden. Die Kupferschichten erhöhen signifikant die Haftung des Lagenaufbaus. Die Kupferschichten sind in der REM-BSE-Aufnahme (BSE- backscattered electrons) in Figur 3b als helle Streifen erkennbar. Die Schichtdicke der Aktivschicht (Multilagenaufbau 16) kann beispielsweise 6µm betragen. Dies entspricht bei 2000mAh/g einer Kapazität von 2,4 mAh/cm². Die Funktion der Klebeschicht 15 kann auch durch eine mechanische Aufrauhung der Oberfläche oder mittels eines anderen Materials als Silizium realisiert werden.

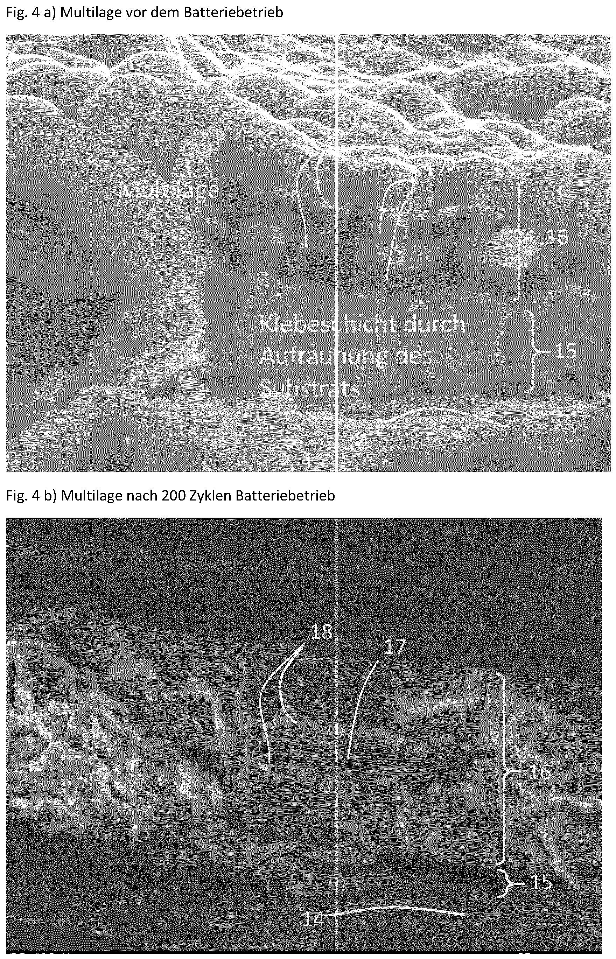

Figur 4a zeigt die Aufnahme eines Multilagenaufbaus 16 gemäß dem erfindungsgemäßen Verfahren vor dem Batteriebetrieb und Figur 4b den gleichen Multilagenaufbau 16 nach 200 Zyklen Batteriebetrieb. Auf einem Kupfersubstrat 14 wurde als Klebeschicht 15 Kupfersilizid, das sich aus einer abgeschiedenen Siliziumschicht und dem Kupfer des Kupfersubstrats durch eine Kurzzeittemperung, insbesondere Blitzlampentemperung gebildet hat, aufgebracht, die eine Aufrauhung des Substrates bewirkt. Darauf wurde ein Multilagenaufbau 16 aus drei Lagen Silizium 17 und zwei Lagen Kupfer 18 abgeschieden, wobei jede Zwischenschicht (Si und Cu) mittels einer Kurzzeittemperung stabilisiert wird. Gegebenenfalls ist eine Kurzzeittemperung auch nur aller zwei (oder mehr) Silizium-Lagen notwendig. Beispielsweise wird in einem ersten Schritt ein Multilagenaufbau aus Si-Cu-Si abgeschieden, der einer Kurzzeittemperung unterzogen wird, anschließend werden weitere Lagen aus Cu und Si abgeschieden, die wiederum einer Kurzzeittemperung unterzogen werden. Das erfindungsgemäße Verfahren ist sehr variabel. Je seltener geblitzt/gelasert und dementsprechend mehr Energie eingespart wird, desto kostengünstiger ist der Gesamtprozess. Auch nach 200 Zyklen Batteriebetrieb bleibt der Multilagenaufbau 16 erhalten und ist erkennbar. Die Oberfläche ist glatt und stabil. Mit dem erfindungsgemäßen Verfahren kann eine 10µm dicke stabile Aktivschicht für die Anode hergestellt werden, wobei dies einer Batteriezellenkapazität bei 2000mAh/g von 4mAh/cm² entspricht.

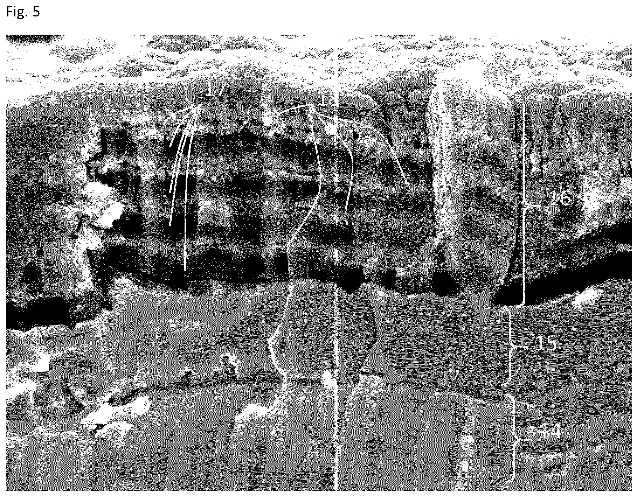

Figur 5 zeigt eine weitere Multilagenstruktur 16, die mit dem erfindungsgemäßen Verfahren hergestellt wurde. Deutlich erkennbar sind das Kupfersubstrat 14, die CuSi_{X} Klebeschicht 15, eine nicht erkennbare 5nm dicke Kohlestoffschicht, sowie fünf Lagen aus Silizium 17, die sich mit Lagen aus Kupfer 18 abwechseln. Die Dicke jeder neu aufgebrachten Kupferlage 18 erhöht sich nach oben. Die Kurzzeittemperung erfolgte mit einer Pulsdauer von 1ms, wobei insgesamt drei Blitze nach der 0., 3. sowie 5. Lage mit variabler Energie durchgeführt wurden. In der untersten Lage erfolgte durch den Energieeintrag der Kurzzeittemperung eine vollständige Reaktion von Cu und Si zu CuSi_{X}, in den oberen Lagen wurde der Energieeintrag so gewählt, dass eine ausreichende partielle Reaktion von Cu mit Si zu CuSi_{X} stattfindet.

### Verfahren zur Herstellung von Silizium-Elektroden als Anoden für Lithium-Batterien

### Bezugszeichenliste

- 1: Lithium-Ionen-Batterie
- 2: Kollektor auf Anoden-Seite
- 3: SEI-Solid-Electrolyte-Interphase
- 4: Elektrolyt
- 5: Separator
- 6: Leitende Zwischenphase, CEI Cathode-Electrolyte Interphase
- 7: Kathode, positive Elektrode
- 8: Kollektor auf Kathodenseite
- 9: Anode, negative Elektrode
- 10: Sputtern der Si-Schicht
- 11: Kurzzeittemperung, z. B. Blitzlampentemperung oder Lasertemperung
- 12: Wiederholung der Prozessschritte
- 13: Sputtern eines zusätzlichen Materials
- 14: Kupfersubstrat
- 15: Klebeschicht
- 16: Multilagenaufbau
- 17: Siliziumlage, weitere Siliziumlage
- 18: Kupferlage
- 19: Weitere Lage
- 20: Metallschicht

## Patentansprüche

1. Verfahren zur Herstellung einer Silizium-Elektrode als Anode für Lithium-Batterien, bei dem auf einem Substrat, vorzugsweise Kupfer (14), eine erste Siliziumschicht (17) abgeschieden wird, die anschließend einer Kurzzeittemperung (11) unterzogen wird, **dadurch gekennzeichnet, dass** die Abscheidung einer weiteren Siliziumschicht (17) und die anschließende Kurzzeittemperung (11) mindestens einmal wiederholt wird, wobei vor dem Abscheiden der ersten Siliziumschicht (17) auf dem Kupfersubstrat (14) eine von Silizium verschiedene Schicht aus Nickel (Ni) und / oder Kupfer (Cu) abgeschieden wird, oder wobei vor dem Abscheiden der weiteren Siliziumschicht (17) eine dünne Lage einer weiteren Schicht (19) aufgebracht wird, wobei die dünne Lage der weiteren Schicht (19) Kohlenstoff, ein Metall, ein Metalloxid oder ein Metallnitrid ist, wobei die dünne Lage der weiteren Schicht (19) aus einem der Materialien Titan (Ti), Nickel (Ni), Aluminium (Al), Zinn (Sn), Gold (Au), Silber (Ag), Wolfram (W) und / oder Kupfer (Cu) gebildet wird, wobei die Kurzzeittemperung (11) eine Blitzlampentemperung ist und mittels einer Blitzlampe mit einer Blitzlichtdauer zwischen 0,2 ms bis 20 ms und einer Energiedichte von 0,6 J/cm² bis 160 J/cm² sowie einer Vorheizung oder Kühlung im Bereich von 4°C bis 200°C durchgeführt wird oder wobei die Kurzzeittemperung (11) eine Lasertemperung ist und mittels eines Lasers mit einer Temperungszeit im Bereich von 0,01 ms bis 100 ms durch das Einstellen einer Scangeschwindigkeit einer lokalen Erhitzungsstelle und einer Energiedichte im Bereich von 0,1 bis 100 J/cm² sowie einer Vorheizung oder Kühlung im Bereich von 4°C bis 200°C durchgeführt wird.

2. Verfahren nach Anspruch 1, **dadurch gekennzeichnet, dass** die Abscheidung einer weiteren Siliziumschicht (17) und die anschließende Kurzzeittemperung (11) zweimal oder mehr als zweimal wiederholt wird.

3. Verfahren nach Anspruch 1, **dadurch gekennzeichnet, dass** auf die weitere Siliziumschicht (17) vor der Kurzzeittemperung (11) eine Metallschicht (20) abgeschieden wird, wobei die Metallschicht (20) aus einem der Materialien Titan (Ti), Nickel (Ni), Aluminium (Al), Zinn (Sn), Gold (Au), Silber (Ag) und / oder Wolfram (W) gebildet wird.

## Claims

1. A method for producing a silicon electrode as anode for lithium batteries, wherein a first silicon layer (17) is deposited on a substrate, preferably copper (14), and subsequently subjected to short-term annealing (11), **characterized in that** the deposition of a further silicon layer (17) and the subsequent short-term annealing (11) are repeated at least once, wherein before the deposition of the first silicon layer (17) on the copper substrate (14), a layer other than silicon made of nickel (Ni and/or copper (Cu) is deposited, or wherein before the deposition of the further silicon layer (17), a thin stratum of a further layer (19) is applied, the thin stratum of the further layer (19) being carbon, a metal, a metal oxide or a metal nitride, wherein the thin stratum of the further layer (19) is formed from one of the materials titanium (Ti), nickel (Ni), aluminum (Al), tin (Sn), gold (Au), silver (Ag), tungsten (W) and/or copper (Cu), wherein the short-term annealing (11) is a flash-lamp annealing and is carried out by means of a flash lamp having a flash light duration of between 0.2 ms to 20 ms and an energy density of 0.6 J/cm² to 160 J/cm² and also of preheating or cooling in the range from 4°C to 200°C, or wherein the short-term annealing (11) is a laser annealing and is carried out by means of a laser with an annealing time in the range from 0.01 ms to 100 ms by the establishment of a rate of scanning of a local heating site and an energy density in the range from 0.1 to 100 J/cm² and also of preheating or cooling in the range from 4°C to 200°C.

2. The method as claimed in claim 1, **characterized in that** the deposition of a further silicon layer (17) and the subsequent short-term annealing (11) are repeated twice or more than twice.

3. The method as claimed in claim 1, **characterized in that** a metal layer (20) is deposited onto the further silicon layer (17) before the short-term annealing (11), wherein the metal layer (20) is formed from one of the materials titanium (Ti), nickel (Ni), aluminum (Al), tin (Sn), gold (Au), silver (Ag) and/or tungsten (W).

## Revendications

1. Procédé de fabrication d'une électrode en silicium servant d'anode pour des batteries au lithium, dans lequel une première couche de silicium (17) est déposée sur un substrat, de préférence en cuivre (14), puis soumise à un recuit de courte durée (11), **caractérisé en ce que** le dépôt d'une autre couche de silicium (17) et le recuit de courte durée (11) qui suit sont répétés au moins une fois, dans lequel, avant le dépôt de la première couche de silicium (17) sur le substrat en cuivre (14), une couche autre que du silicium, constituée de nickel (Ni) et/ou de cuivre (Cu), est déposée, ou dans lequel, avant le dépôt de l'autre couche de silicium (17), une fine couche d'une autre couche (19) est appliquée, la fine couche de l'autre couche (19) étant du carbone, un métal, un oxyde métallique ou un nitrure métallique, la fine couche de l'autre couche (19) étant formée à partir de l'un des matériaux suivants: titane (Ti), nickel (Ni), aluminium (Al), étain (Sn), or (Au), argent (Ag), tungstène (W) et/ou cuivre (Cu), dans lequel le recuit de courte durée (11) est un recuit par lampe flash et est réalisé au moyen d'une lampe flash ayant une durée d'éclair comprise entre 0,2 ms et 20 ms et une densité d'énergie de 0,6 J/cm² à 160 J/cm², ainsi que par un préchauffage ou un refroidissement dans la plage de 4 °C à 200 °C, ou dans lequel le recuit de courte durée (11) est un recuit au laser et est réalisé au moyen d'un laser avec un temps de recuit compris entre 0,01 ms et 100 ms, par la mise en place d'une vitesse de balayage d'une zone de chauffage locale et d'une densité d'énergie comprise entre 0,1 et 100 J/cm², ainsi que d'un préchauffage ou d'un refroidissement dans la plage de 4 °C à 200 °C.

2. Procédé selon la revendication 1, **caractérisé en ce que** le dépôt d'une couche de silicium supplémentaire (17) et le recuit de courte durée (11) qui suit sont répétés deux fois ou plus de deux fois.

3. Procédé selon la revendication 1, **caractérisé en ce qu'**une couche métallique (20) est déposée sur la couche de silicium supplémentaire (17) avant le recuit de courte durée (11), la couche métallique (20) étant formée à partir de l'un des matériaux suivants: titane (Ti), nickel (Ni), aluminium (Al), étain (Sn), or (Au), argent (Ag) et/ou tungstène (W).
